# FASCICULE DE BREVET EUROPEEN

(11) **EP 3 154 061 B1**
(45) Date de publication et mention de la délivrance du brevet: **14.11.2018**
(21) Numéro de dépôt: 16192626.6
(22) Date de dépôt: 06.10.2016
(51) Int. Cl.: G11C 13/00, G11C 11/16

(54) **PROCÉDÉ ET CIRCUIT POUR CONTRÔLER LE COURANT DE PROGRAMMATION DANS UNE MATRICE DE MÉMOIRE NON VOLATILE**
VERFAHREN UND SCHALTKREIS ZUR STEUERUNG DES STROMS EINER PROGRAMMIERUNG IN EINER NICHT-FLÜCHTIGEN SPEICHERMATRIX
METHOD AND CIRCUIT FOR CONTROLLING THE PROGRAMMING CURRENT IN A NON-VOLATILE MEMORY ARRAY

(30) Priorité: 09.10.2015 FR 1559648
(43) Date de publication de la demande: 12.04.2017
(73) Titulaire: COMMISSARIAT À L'ÉNERGIE ATOMIQUE ET AUX ÉNERGIES ALTERNATIVES, 75015 Paris (FR)
(72) Inventeur: LEVISSE, Alexandre, 38000 GRENOBLE (FR)
(74) Mandataire: Cabinet Beaumont

(56) Documents cités:
- US-A1- 2013 114 327
- US-A1- 2013 148 406
- US-A1- 2014 112 056

## Description

### Domaine

La présente description concerne le domaine des mémoires non volatiles, et en particulier un procédé et un circuit pour contrôler le courant de programmation de cellules de mémoire non volatile dans une matrice mémoire à points d'intersection (mémoire connue aussi sous le nom anglais de mémoire "cross-point").

### Exposé de l'art antérieur

On a déjà proposé d'utiliser des éléments résistifs programmables dans des cellules mémoires pour assurer une mémorisation de données non volatile. De tels éléments résistifs sont programmables pour prendre l'un d'une pluralité d'états résistifs différents. L'état résistif programmé est conservé lorsque la tension d'alimentation de la cellule mémoire est déconnectée, et ainsi des données peuvent être mémorisées de façon non volatile.

Divers types d'éléments résistifs ont été proposés, dont certains peuvent être programmés par la direction et/ou le niveau du courant qu'on fait passer dans l'élément. Des exemples de tels éléments résistifs programmables par un courant comprennent les OxRAM (de l'anglais Oxyde Random Access Memory - mémoire à accès aléatoire à oxyde), les PC-RAM (Phase Change Random Access Memory - mémoire à accès aléatoire à changement de phase) et les MRAM (Magnetic RAM - mémoire à accès aléatoire magnétique) utilisant par exemple la technologie STT (couple de transfert de SPIN).

Afin d'obtenir une matrice mémoire compacte, on a proposé d'incorporer des cellules de mémoire non volatile dans une architecture de matrice mémoire à points d'intersection. Dans une telle matrice, des cellules mémoires sont agencées en rangées et en colonnes, chaque rangée ayant une piste conductrice de rangée associée, et chaque colonne ayant une piste conductrice de colonne associée. Chaque cellule mémoire comprend un élément résistif programmable couplé entre une piste conductrice de rangée correspondante et une piste conductrice de colonne correspondante. Ainsi, en appliquant des niveaux de tension particuliers aux pistes conductrices de colonne et de rangée, une cellule mémoire peut être sélectionnée dans la matrice pour une opération de lecture ou d'écriture.

En fonction de la technologie particulière de l'élément résistif programmable non volatil, le niveau du courant de programmation utilisé pendant l'opération de programmation peut affecter une certaine propriété de l'état résistif programmé, comme la résistance programmée et/ou la durée de rétention de la donnée.

Par exemple, dans le cas d'une cellule mémoire OxRAM, lorsqu'on passe de l'état résistif haut à l'état résistif bas, le courant de programmation va monter rapidement et le niveau atteint par le courant de programmation va déterminer le niveau de résistance programmé de la cellule. Par conséquent, afin de programmer une résistance souhaitée particulière, le courant devrait être limité pendant l'opération de programmation.

Toutefois, une difficulté dans les matrices de mémoire à points d'intersection est que, pendant qu'une cellule mémoire donnée est en cours de programmation, une certaine quantité du courant envoyé dans la matrice va être perdue par des fuites de courant dans des cellules mémoires non sélectionnées. De tels chemins de courant sont connus dans la technique sous le nom de chemins furtifs (de l'anglais "sneak path"). La quantité de courant passant par des chemins furtifs va dépendre de divers facteurs, comme les états résistifs des cellules mémoires non sélectionnées, la position de la cellule mémoire sélectionnée dans la matrice, les conditions de fonctionnement, l'âge du dispositif et les performances d'autres composants dans chaque cellule mémoire. Il existe donc un problème technique pour compenser de façon appropriée de tels courants de fuite.

Ainsi il existe un besoin dans la technique pour un circuit et un procédé assurant une limitation de courant effective pendant des opérations de programmation dans une matrice de mémoire non volatile à points d'intersection.

La demande de brevet US 2014/0112056 concerne un dispositif mémoire non-volatile comprenant une matrice mémoire à points d'intersection.

### Résumé

Un objet de modes de réalisation de la présente description est de résoudre au moins partiellement un ou plusieurs besoin de l'art antérieur.

Selon un aspect, on prévoit un dispositif mémoire comprenant : une matrice mémoire à points d'intersection comprenant une pluralité de pistes conductrices de rangée, une pluralité de pistes conductrices de colonne et une pluralité de cellules mémoires agencées en rangées et en colonnes, chaque cellule mémoire comprenant un élément résistif programmable non volatil couplé entre l'une correspondante des pistes conductrices de rangée et l'une correspondante des pistes conductrices de colonne ; un circuit d'alimentation en courant adapté à fournir un courant de programmation à l'une sélectionnée des pistes conductrices de rangée pendant une opération de programmation pour changer l'état résistif d'une cellule mémoire sélectionnée couplée entre la piste conductrice de rangée sélectionnée et l'une sélectionnée des pistes conductrices de colonne ; un circuit de détection de courants de fuite couplé à la pluralité de pistes conductrices de colonne excepté à la piste conductrice de colonne sélectionnée et adapté à détecter des courants de fuite pendant l'opération de programmation ; et un circuit de génération de limite de courant adapté à générer une limite de courant sur la base de la somme des courants de fuite et d'un courant de référence, et à fournir la limite de courant au circuit d'alimentation en courant pour limiter le courant de programmation.

Selon un mode de réalisation, le circuit de génération de limite de courant est adapté à générer la limite de courant en ajoutant la somme des courants de fuite au courant de référence, le courant de référence représentant le courant de programmation à appliquer à la cellule mémoire sélectionnée.

Selon un mode de réalisation, le circuit d'alimentation en courant comprend un régulateur de tension pour contrôler un premier niveau de tension appliqué à la piste conductrice de rangée sélectionnée.

Selon un mode de réalisation, le régulateur de tension comprend un premier transistor couplé à la piste conductrice de rangée sélectionnée et ayant son noeud de commande couplé à la sortie d'un comparateur adapté à comparer la tension sur la piste conductrice de rangée sélectionnée à une tension de référence égale au premier niveau de tension.

Selon un mode de réalisation, le circuit d'alimentation en courant comprend un miroir de courant ayant une branche de référence couplée de façon à recevoir la limite de courant et une autre branche couplée à la piste conductrice de rangée sélectionnée.

Selon un mode de réalisation, le circuit d'alimentation en courant comprend un autre comparateur adapté à comparer un premier niveau de tension généré sur la base de la limite de courant à un deuxième niveau de tension généré sur la base du courant de programmation, et à contrôler le courant de programmation sur la base de la comparaison.

Selon un mode de réalisation, le circuit de détection de courants de fuite comprend un régulateur de tension pour contrôler un deuxième niveau de tension appliqué aux pistes conductrices de colonne excepté à la piste conductrice de colonne sélectionnée.

Selon un mode de réalisation, le circuit de génération de limite de courant comprend : un premier miroir de courant ayant une branche de référence couplée de façon à recevoir la somme des courants de fuite, et une autre branche ; un deuxième miroir de courant ayant une branche de référence couplée de façon à recevoir le courant de référence, et une autre branche, les autres branches des premier et deuxième miroirs de courant étant couplées à une ligne de sortie du circuit de génération de limite de courant fournissant la limite de courant.

Selon un mode de réalisation, le dispositif mémoire comprend : un ou plusieurs autres circuits d'alimentation en courant adaptés à fournir un courant de programmation à une ou plusieurs autres pistes conductrices de rangée sélectionnées pendant l'opération de programmation pour changer l'état résistif d'une ou plusieurs des cellules mémoires couplées à la piste conductrice de colonne sélectionnée ; et un circuit de division adapté à diviser la somme des courants de fuite par le nombre de circuits d'alimentation en courant.

Selon un mode de réalisation, l'élément résistif programmable non volatil est sélectionné parmi un dispositif OxRAM (mémoire à accès aléatoire à oxyde), un dispositif PCM (mémoire à changement de phase) et un dispositif MRAM (RAM magnétique).

Selon un mode de réalisation, chaque cellule mémoire comprend en outre un dispositif à sélection bidirectionnelle couplé en série avec l'élément résistif programmable non volatil et adapté à conduire au-dessus d'un seuil de tension.

Selon un autre aspect on prévoit un procédé pour limiter un courant de programmation dans une matrice de mémoire non volatile à points d'intersection comprenant une pluralité de pistes conductrices de rangée, une pluralité de pistes conductrices de colonne et une pluralité de cellules mémoires agencées en rangées et en colonnes, chaque cellule mémoire comprenant un élément résistif programmable non volatil couplé entre l'une correspondante des pistes conductrices de rangée et l'une correspondante des pistes conductrices de colonne, le procédé comprenant : fournir, par un circuit d'alimentation en courant, un courant de programmation à l'une sélectionnée des pistes conductrices de rangée pendant une opération de programmation pour changer l'état résistif d'une cellule mémoire sélectionnée couplée entre la piste conductrice de rangée sélectionnée et l'une sélectionnée des pistes conductrices de colonne ; détecter, par un circuit de détection de courants de fuite couplé à la pluralité de pistes conductrices de colonne excepté à la piste conductrice de colonne sélectionnée, des courants de fuite pendant l'opération de programmation ; générer, par un circuit de génération de limite de courant, une limite de courant sur la base de la somme des courants de fuite et d'un courant de référence ; et fournir la limite de courant au circuit d'alimentation en courant pour limiter le courant de programmation.

### Brève description des dessins

Les caractéristiques et avantages susmentionnés et d'autres apparaîtront avec la description détaillée suivante de modes de réalisation, donnés à titre d'illustration et non de limitation, en faisant référence aux dessins joints dans lesquels :
la figure 1A illustre schématiquement une matrice mémoire à points d'intersection selon un exemple de réalisation ;
la figure 1B illustre schématiquement une cellule mémoire non volatile de la matrice de la figure 1A plus en détail selon un exemple de réalisation ;
la figure 2 est un graphique représentant une relation courant-tension aux bornes de la cellule mémoire de la figure 1B selon un exemple de réalisation ;
la figure 3 illustre schématiquement un dispositif mémoire muni d'un circuit de limitation de courant selon un exemple de réalisation de la présente description ;
la figure 4 illustre schématiquement un dispositif mémoire muni d'un circuit de limitation de courant selon un autre exemple de réalisation de la présente description ;
la figure 5 est un organigramme illustrant des étapes dans un procédé de limitation d'un courant de programmation dans une cellule mémoire non volatile selon un exemple de réalisation de la présente description ;
la figure 6 illustre schématiquement le dispositif mémoire de la figure 3 plus en détail selon un exemple de réalisation ;
la figure 7 illustre schématiquement le dispositif mémoire de la figure 3 plus en détail selon un autre exemple de réalisation ;
la figure 8 illustre schématiquement un dispositif mémoire muni d'un circuit de limitation de courant selon un autre exemple de réalisation dans lequel plusieurs cellules mémoire peuvent être programmées à la fois ; et
la figure 9 illustre schématiquement le dispositif mémoire de la figure 8 plus en détail selon un exemple de réalisation.

### Description détaillée

Dans la présente description, le terme "connecté" est utilisé pour désigner une connexion électrique directe entre deux éléments, alors que le terme "couplé" est utilisé pour désigner une connexion électrique entre deux éléments qui peut être directe, ou qui peut se faire par l'intermédiaire d'un ou plusieurs composants tels que des résistances, des condensateurs, ou des transistors. En outre, tel qu'il est utilisé ici, le terme "autour de" est utilisé pour désigner une plage de ±10 % autour de la valeur en question.

Tel qu'il est utilisé ici, le terme "piste conductrice de colonne" est utilisé pour désigner les pistes conductrices d'une matrice mémoire dessinées verticalement dans les figures, alors que le terme "piste conductrice de rangée" est utilisé pour désigner les pistes conductrices de la matrice mémoire dessinées horizontalement dans les figures. Il apparaitra clairement à l'homme de l'art qu'en pratique les pistes conductrices de rangée et les pistes conductrices de colonne pourraient avoir une orientation quelconque.

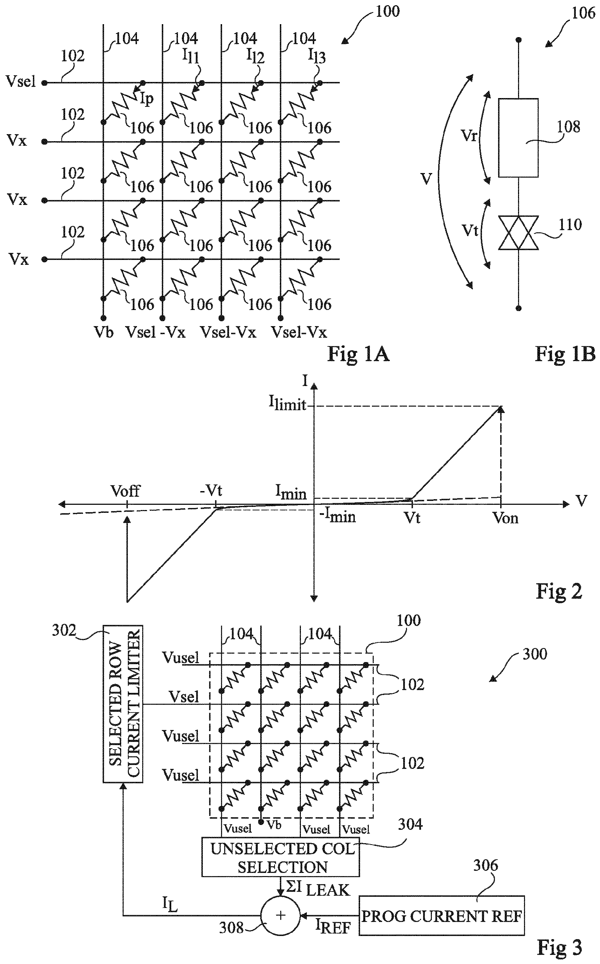

La figure 1A illustre schématiquement un exemple de matrice mémoire à points d'intersection 100 selon un exemple de réalisation. Comme cela est illustré, la matrice 100 comprend par exemple des pistes conductrices de rangée 102 et des pistes conductrices de colonne 104. Dans l'exemple de la figure 1A, la matrice comprend quatre pistes conductrices de rangée et quatre pistes conductrices de colonne, bien que dans des variantes de réalisation il puisse y avoir un nombre n quelconque de pistes conductrices de rangée et un nombre m quelconque de pistes conductrices de colonne, où n et m sont tous deux par exemple des entiers égaux ou supérieurs à deux.

La matrice mémoire 100 comprend des cellules mémoires 106 agencées en rangées et en colonnes, une rangée de cellules mémoires pour chaque piste conductrice de rangée, et une colonne de cellules mémoires pour chaque piste conductrice de colonne. Chaque cellule mémoire est couplée entre une piste conductrice de rangée correspondante 102 et une piste conductrice de colonne correspondante 104. Par exemple, les cellules mémoires dans la colonne du côté gauche de la matrice ont toutes une borne couplée à la piste conductrice de colonne 104 du côté gauche, et leurs autres bornes couplées aux pistes conductrices de rangée 102 correspondantes.

Une cellule mémoire de la matrice peut être sélectionnée pendant une opération de lecture ou d'écriture en appliquant des tensions appropriées à des pistes conductrices de rangée et de colonne afin de faire passer un courant dans la cellule mémoire sélectionnée. Un exemple est représenté en figure 1A dans lequel, pendant une opération d'écriture, une cellule mémoire située dans le coin supérieur gauche de la matrice est sélectionnée en appliquant une tension de sélection Vsel à la piste conductrice de rangée 102 supérieure et une tension basse Vb à la piste conductrice de colonne 104 de gauche. Ainsi, la cellule mémoire supérieure gauche de la matrice a une tension de Vsel-Vb à ses bornes. Par exemple, Vsel est à environ la tension d'alimentation VDDH du circuit, qui est par exemple dans la plage de 1 à 3 V, et Vb est à 0 V ou autour de cette valeur. Par exemple, un courant appliqué à une cellule mémoire sélectionnée à partir de la piste conductrice de rangée vers la piste conductrice de colonne provoque la commutation de l'élément résistif programmable d'un état de résistance haute à un état de résistance basse. Pour programmer l'élément résistif pour prendre un état de résistance différent, un courant est par exemple appliqué à partir de la piste conductrice de colonne vers la piste conductrice de rangée de la cellule mémoire, ou un niveau de courant différent est appliqué.

Les autres pistes conductrices de rangée 102 ont une tension Vx qui leur est appliquée, et les autres pistes conductrices de colonne ont une tension Vsel-Vx qui leur est appliquée. Les cellules mémoires 106 comprennent chacune par exemple un dispositif à sélection bidirectionnelle, décrit plus en détail ci-après, qui est un dispositif non linéaire associé à un niveau de seuil Vt. Le niveau de seuil Vt est par exemple inférieur à Vx. Lorsque la tension aux bornes du dispositif de sélection est supérieure au niveau de seuil Vt, le dispositif de sélection assure un chemin de résistance relativement faible, permettant le passage d'un courant relativement élevé dans celui-ci. Lorsque la tension aux bornes du dispositif de sélection est inférieure à la tension de seuil Vt, le dispositif de sélection présente un chemin de résistance relativement élevé, de sorte que le courant passant dans celui-ci est relativement faible, ce courant correspondant à un courant de fuite. La somme de ces courants de fuite passant dans de multiples chemins furtifs dans la matrice, correspondant aux cellules mémoires non sélectionnées, peut être significative, et c'est pourquoi il est souhaitable d'assurer une compensation pour ces courants de fuite.

Le niveau de Vx est choisi de façon à être entre Vb et Vsel. Par exemple, Vx est égal à ou compris entre Vsel/2 et Vsel/3. Dans le cas où Vx = Vsel/2 et Vb = 0 V, la tension aux bornes des cellules mémoires dans la colonne de gauche de la matrice et dans la rangée supérieure de la matrice va être égale à Vsel/2, et la tension aux bornes de toutes les autres cellules mémoires de la matrice va être 0 V. Dans le cas où Vx = Vsel/3 et Vb = 0 V, la tension aux bornes de toutes les cellules mémoires dans la matrice, excepté la cellule mémoire se trouvant dans le coin supérieur gauche, va être Vsel/3. Le niveau de la tension Vx est par exemple choisi de façon à minimiser le courant de fuite dans la matrice, et généralement pour la plupart des tailles de matrice, un niveau de Vsel/2 fonctionne bien.

La plus grande partie du courant résultant des niveaux de tension Vsel et Vb va passer à travers la cellule mémoire sélectionnée. Cependant, comme cela a été mentionné précédemment, une partie du courant va être perdue en raison de la fuite de courant par les chemins furtifs dans les cellules mémoires passant à travers d'autres cellules mémoires non sélectionnées. Par exemple, lorsque la tension Vsel est appliquée à la piste conductrice de rangée supérieure 102 de la matrice, un courant de programmation Ip va circuler dans la cellule mémoire du haut à gauche et des courants de fuite (I₁₁, I₁₂ et I₁₃) peuvent circuler à travers les autres cellules mémoires dans la rangée supérieure de la matrice, en fonction du niveau de tension Vsel - Vx. Ces courants de fuite vont réduire le courant de programmation I_{P} passant dans la cellule mémoire sélectionnée.

La figure 1B illustre un exemple de la cellule mémoire 106 de la matrice de la figure 1A selon un exemple de réalisation. Chaque cellule mémoire 106 comprend par exemple un élément résistif programmable 108 couplé en série avec un dispositif à sélection bidirectionnelle 110.

L'élément résistif programmable 108 est par exemple un dispositif bipolaire programmable par la polarité du courant de programmation qu'on fait passer dedans. Par exemple, l'élément 108 est un dispositif OxRAM (RAM à oxyde), un dispositif PCM (mémoire à changement de phase) ou un dispositif MRAM (RAM magnétique) basé sur la technologie STT (couple de transfert de spin) .

Comme cela a été mentionné précédemment, le dispositif à sélection bidirectionnelle 110 est un dispositif bipolaire non linéaire, qui va laisser passer un courant dans l'une ou l'autre direction lorsqu'un seuil de tension Vt à ses bornes est atteint. En dessous du seuil de tension Vt, le dispositif 110 par exemple laisse passer un courant relativement faible. Ainsi, le dispositif de sélection se comporte par exemple comme une diode bidirectionnelle. Par exemple, comme cela est connu de l'homme de l'art, un tel dispositif à sélection bidirectionnelle peut être formé, entre autres, par : un dispositif à barrière tunnel, une structure MIM (métal-isolant-métal) basée sur une émission Schottky ; ou un dispositif à commutation à seuil bidirectionnel induite par un chauffage à effet joule. Par exemple, de tels dispositifs sont décrits plus en détail dans la publication de J. Woo et al., intitulée "Selector Devices for High Density Cross-point ReRAM", 14th Non-Volatile Memory Technology Symposium (NVMTS 2014) Oct 27th - 29th, 2014, Jeju, Korea, dont le contenu est considéré inclus ici dans les limites autorisées par la loi.

Ainsi, lorsqu'une tension V>Vt est appliquée aux bornes de la cellule mémoire, la chute de tension Vr dans l'élément résistif 108 va être égale à V-Vt. La tension de seuil Vt est par exemple choisie supérieure à Vsel/2, de sorte qu'il va passer un courant relativement faible dans les cellules mémoires non sélectionnées dans la matrice. Dans un mode de réalisation, Vt est choisi dans la plage de 0,8 à 1,5 V, et est par exemple égal à environ 1 V. La tension V est par exemple dans la plage de 1 à 3 V et est par exemple égale à environ 2 V, et la tension Vr aux bornes de l'élément résistif pendant une phase de programmation est dans la plage de 1 à 2 V, et par exemple autour de 1,4 V.

La figure 2 est un graphique illustrant un exemple des tensions de programmation et des courants résultants dans la cellule mémoire 106 de la figure 1B selon un exemple de réalisation dans lequel l'élément résistif 108 est mis en oeuvre par un dispositif OxRAM.

Comme cela est représenté par une courbe en trait plein, lorsque l'élément résistif 108 est dans l'état résistif bas, jusqu'à ce que la tension de seuil Vt ou -Vt soit atteinte, le courant dans la cellule mémoire va être à un niveau bas de Iₘᵢₙ ou moins. Dans l'exemple de la figure 2, les seuils positif et négatif Vt, -Vt sont de la même amplitude, mais il serait possible dans certains modes de réalisation que ces seuils aient des amplitudes différentes. Lorsque la tension est supérieure à Vt ou inférieure à -Vt, le courant est proportionnel à V-Vt. Cependant, si un niveau négatif Voff est atteint, l'élément résistif va commuter dans l'état résistif haut, et le courant va tomber à un niveau relativement faible.

Comme cela est représenté par une courbe en trait interrompu, lorsque l'élément résistif 108 est dans l'état résistif haut et que la tension aux bornes de la cellule mémoire passe au-dessus de Vt et atteint un niveau Von, le courant monte brusquement lorsque l'élément résistif commute sur l'état résistif bas. Le courant augmente jusqu'à ce qu'une certaine limite de courant Iₗᵢₘᵢₜ soit atteinte. Le niveau de cette limite de courant détermine la résistance de l'élément résistif dans l'état résistif bas.

Dans le cas d'autres types d'éléments résistifs, le comportement du dispositif lorsque la tension Von est atteinte peut être différent. Par exemple, dans des cellules mémoires basées sur des technologies MRAM, la limite de courant ne règle pas le niveau de résistance de l'état résistif bas, mais détermine la durée de rétention. Dans un autre exemple, dans des technologies PCM (mémoire à changement de phase), la limite de courant détermine le volume de matériau qui est programmé, et ainsi a un impact sur la résistance du dispositif. On notera que les dispositifs PCM sont programmés de façon unipolaire, ce qui signifie que ce n'est pas la direction du courant de programmation, mais le niveau du courant, qui détermine la résistance programmée.

Il y a donc intérêt à limiter le courant, avec une précision relativement élevée, à une limite de courant souhaitée Iₗᵢₘᵢₜ afin de contrôler les propriétés résistives de l'élément résistif.

La figure 3 illustre un dispositif mémoire 300 comprenant la matrice de mémoire non volatile à points d'intersection 100 de la figure 1A et comprenant des circuits pour limiter le courant de programmation selon un exemple de réalisation. Comme cela a été mentionné en relation avec la figure 1A, alors que la matrice mémoire ne comprend que seulement quatre rangées et quatre colonnes de cellules mémoires, dans des variantes de réalisation elle pourrait comprendre un nombre quelconque n de rangées et un nombre quelconque m de colonnes.

Un circuit limiteur de courant de rangée sélectionnée (SELECTED ROW CURRENT LIMITER) 302 est par exemple couplé à la piste conductrice de rangée sélectionnée, et est adapté à appliquer un niveau de tension de piste conductrice sélectionnée Vsel à cette piste conductrice de rangée. En outre, le circuit 302 est adapté à limiter le courant fourni à cette piste conductrice de rangée. Les autres pistes conductrices de rangées sont par exemple couplées à une tension de piste conductrice non sélectionnée Vusel, qui correspond par exemple à la tension Vx de la figure 1A, par un circuit de commande de rangée (non illustré dans les figures).

Un circuit de sélection de colonne (non illustré dans les figures) est par exemple adapté à coupler l'une sélectionnée des pistes conductrices de colonne à la tension Vb. Un circuit de sélection de colonne non sélectionnée (UNSELECTED COL SELECTION) 304 est par exemple adapté à appliquer la tension de piste conductrice non sélectionnée Vusel à chacune des pistes conductrices de colonne non sélectionnées. Ainsi, dans l'exemple de la figure 3, une même tension est par exemple appliquée à des pistes conductrices de rangée non sélectionnées et à des pistes conductrices de colonne non sélectionnées. Dans certains modes de réalisation, la tension Vb est égale à 0 V, et la tension Vusel est égale à environ Vsel/2. Cependant, en fonction du niveau de Vsel, la tension Vsel/2 peut ne pas être suffisamment élevée pour polariser correctement des transistors dans le circuit 304. Dans un tel cas, la tension Vb peut être choisie de façon à être positive, par exemple égale à environ 0,5 V, et les autres tensions décalées en conséquence. Ainsi, par exemple, plutôt que d'être égale à Vsel/2, la tension Vusel est par exemple égale à Vb+(Vsel-vB)/2.

Le circuit 304 est aussi par exemple adapté à générer une somme **∑*I_{LEAK}*** des courants de fuite sur les pistes conductrices de colonne non sélectionnées.

Dans l'exemple de la figure 3, la deuxième cellule mémoire à partir du haut et deuxième à partir de la gauche est sélectionnée.

Un circuit de référence de courant de programmation (PROG CURRENT REF) 306 est par exemple adapté à générer un courant de référence I_{REF} correspondant à une limite de courant de programmation souhaitée Iₗᵢₘᵢₜ de la cellule mémoire à programmer. Un additionneur 308 est par exemple adapté à ajouter le courant de référence I_{REF} à la somme **∑*I_{LEAK}*** des courants de fuite afin de générer une limite de courant I_{L}. Cette limite de courant I_{L} est fournie au circuit limiteur de courant de rangée sélectionnée 302, et est utilisée par ce circuit pour limiter le courant dans la piste conductrice de rangée sélectionnée.

Dans certains modes de réalisation, l'élément résistif programmable de chaque cellule mémoire est un élément, comme un élément OxRAM, ayant un état de résistance bas qui dépend du niveau atteint par le courant de programmation pendant la phase de programmation. Dans un tel cas, le dispositif mémoire est par exemple capable de programmer chaque élément résistif de façon à prendre l'un d'une pluralité d'états résistifs bas, ce qui permet à chaque élément de mémoriser plus qu'un seul bit de données. Ceci est par exemple obtenu en fixant, pendant chaque phase de programmation, une valeur appropriée du courant de référence I_{REF} parmi une pluralité de niveaux sélectionnables de telle sorte que le courant de programmation soit limité à un niveau correspondant à un état de résistance bas souhaité. Par exemple, dans un mode de réalisation, il y a trois courants de programmation distincts pour programmer trois états de résistance bas distincts (LRS), et un état de résistance haut (HRS). Ainsi, il y a un total de quatre états résistifs distincts, ce qui permet de mémoriser deux bits de données dans chaque élément résistif programmable.

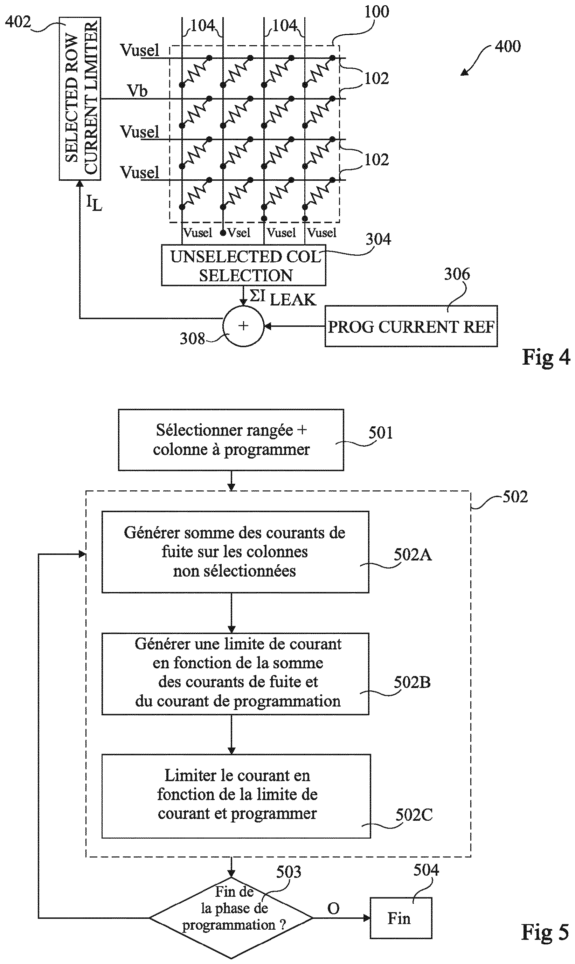

Bien que dans l'exemple de la figure 3, la limite de courant I_{L} soit imposée par le circuit qui fournit la tension d'alimentation Vsel, dans des variantes de réalisation, la limite de courant pourrait être imposée par le circuit qui fournit la tension d'alimentation Vb, comme on va le décrire maintenant en faisant référence à la figure 4.

La figure 4 illustre schématiquement un circuit de mémoire non volatile 400 selon une variante de réalisation par rapport à la figure 3. Comme cela est illustré, le circuit de commande de colonnes (non illustré dans les figures) est adapté à coupler une piste conductrice de colonne sélectionnée à une tension Vsel plutôt qu'à la tension Vb. En outre, le circuit 302 est remplacé par un circuit limiteur de courant de rangée sélectionnée 402 adapté à appliquer une tension Vb à la piste conductrice de rangée sélectionnée, et à limiter le courant à une valeur I_{L} de façon similaire au circuit 302.

La figure 5 est un organigramme illustrant des étapes dans un procédé de limitation de courant de programmation dans une matrice mémoire non volatile à points d'intersection, comme la matrice 100 de la figure 1A.

Dans une étape 501, une piste conductrice de rangée et une piste conductrice de colonne d'une cellule mémoire à programmer sont sélectionnées. Par exemple, la piste conductrice de rangée sélectionnée est couplée au niveau de tension Vsel, et la piste conductrice de colonne sélectionnée est couplée à la tension Vb, ou vice versa. Cela déclenche le début de la phase de programmation.

Dans une étape suivante 502, le courant fourni à la piste conductrice de rangée sélectionnée est limité sur la base d'une limite de courant I_{L}. En particulier, l'étape 502 comprend par exemple les sous-étapes 502A à 502C suivantes, qui sont toutes par exemple réalisées de façon continue pendant la phase de programmation de la cellule mémoire.

Dans l'étape 502A, le courant de fuite sur les pistes conductrices de colonne non sélectionnées pendant la phase de programmation est détecté et additionné pour générer la somme **∑*****I_{LEAK}.*** La somme **∑*I_{LEAK}*** est par exemple représentée par un niveau de courant, bien que dans des variantes de réalisation elle puisse être représentée par un niveau de tension.

Dans l'étape 502B, la limite de courant I_{L} est générée sur la base de la somme des courants de fuite et du courant de programmation de référence I_{REF}. Ici encore, la limite de courant I_{L} est par exemple représentée par un niveau de courant, bien que dans des variantes de réalisation elle puisse être représentée par un niveau de tension.

Dans l'étape 502C, le courant fourni à la piste conductrice de rangée sélectionnée pendant la phase de programmation est limité sur la base de la limite de courant.

Après l'étape 502, une étape 503 est réalisée, pendant laquelle on détermine si la fin de la phase de programmation a été atteinte. Par exemple, dans certains modes de réalisation, cela implique de déterminer si la limite de courant I_{L} a été atteinte, et si oui, la tension Vsel n'est plus appliquée à la piste conductrice de rangée ou de colonne sélectionnée, terminant ainsi la phase de programmation. Dans l'autre cas, la phase de programmation continue toujours pendant un certain temps. Si la phase de programmation n'a pas encore pris fin, l'étape 502 continue. Une fois la fin de la phase de programmation atteinte, le procédé se termine à l'étape 504.

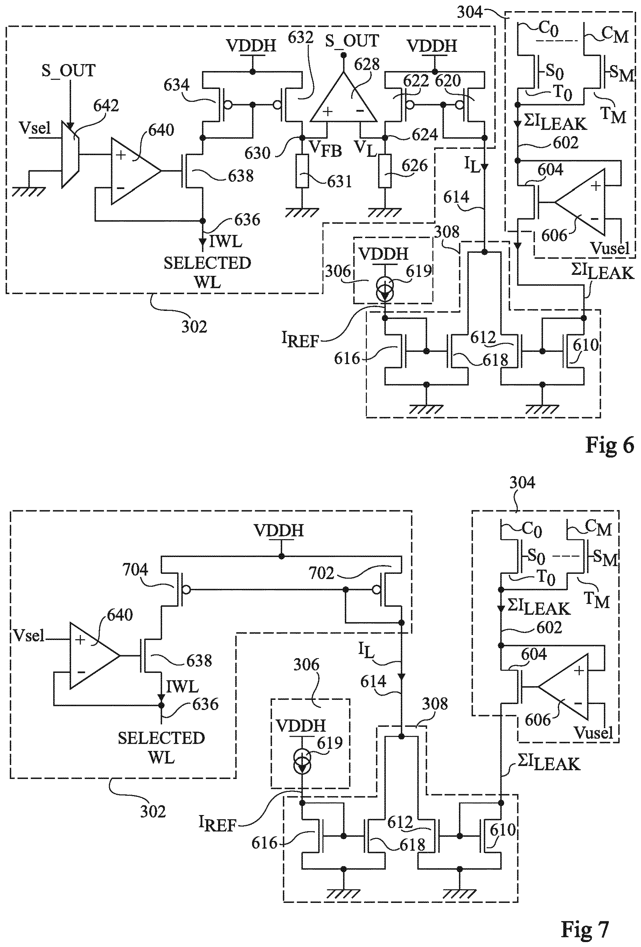

La figure 6 illustre schématiquement le dispositif mémoire 300 de la figure 3 plus en détail selon un exemple de réalisation. La façon dont la mise en oeuvre de la figure 6 pourrait être adaptée pour mettre en oeuvre le dispositif mémoire 400 de la figure 4 apparaitra facilement à l'homme de l'art.

Le circuit de sélection de colonne non sélectionnée 304 comprend par exemple une ligne 602 couplée à chacune des pistes conductrices de colonne non sélectionnées. Par exemple, la ligne 602 est couplée à chacune des pistes conductrices de colonne, notées C₀ à C_{M} en figure 6, par l'intermédiaire d'un transistor NMOS de sélection correspondant T₀ à T_{M}, contrôlé par un signal de commande correspondant S₀ à S_{M}. La totalité des signaux de commande S₀ à S_{M} est par exemple activée pendant une phase de programmation, excepté le signal correspondant à la piste conductrice de colonne sélectionnée. La ligne 602 fournit la somme des courants de fuite **∑*I_{LEAK}***.

La tension Vusel est par exemple appliquée à chacune des pistes conductrices de colonne non sélectionnées parmi les pistes conductrices C₀ à C_{M} par un régulateur de tension formé par un transistor NMOS 604 ayant l'un de ses noeuds de conduction principaux couplé à la ligne 602 et ayant son noeud de commande contrôlé par un comparateur 606, qui est par exemple mis en oeuvre par un amplificateur opérationnel. Le comparateur 606 a l'une de ses entrées couplée à la ligne 602, et son autre entrée couplée au niveau de tension Vusel, qui est par exemple au niveau de ou à proximité de Vsel/2. L'autre noeud de conduction principal du transistor 604 est couplé à une ligne de sortie du circuit 304 fournissant la somme **∑*I_{LEAK}*** des courants de fuite, et est par exemple couplé au rail de masse par l'intermédiaire d'un transistor NMOS 610.

L'additionneur 308 est par exemple mis en oeuvre par une paire de miroirs de courant. Un premier miroir de courant est formé par le transistor 610 et un autre transistor NMOS 612 couplé entre une ligne de sortie 614 de l'additionneur et le rail de masse. Les noeuds de commande des transistors 610, 612 sont couplés entre eux et au drain du transistor 610, de telle sorte que le transistor 610 forme la branche de référence du miroir de courant, et le transistor 612 laisse passer un courant basé sur le courant **∑*****I_{LEAK}.*** L'autre miroir de courant est formé par un transistor NMOS 616 couplé entre le circuit de référence de courant de programmation 306 et le rail de masse, et un transistor NMOS 618 couplé entre la ligne 614 et le rail de masse. Le circuit 306 comprend par exemple une source de courant 619 couplée entre le transistor 616 et un rail de tension d'alimentation VDDH, la source de courant 619 fournissant le courant de référence I_{REF} à l'additionneur 308. Les noeuds de commande des transistors 616, 618 sont couplés entre eux et au drain du transistor 616, de sorte que le transistor 616 forme la branche de référence du miroir de courant, et le transistor 618 laisse passer un courant basé sur le courant de référence I_{REF}.

Dans certains modes de réalisation, les transistors 612 et 618 ont les mêmes dimensions que les transistors 610 et 616, de sorte que le transistor 612 laisse passer le courant **∑*I_{LEAK}*** et le transistor 618 laisse passer le courant I_{REF}. Toutefois, dans des variantes de réalisation, il serait possible que ces transistors aient des dimensions différentes afin que les courants I_{REF} et **∑*I_{LEAK}*** soient augmentés ou diminués d'un même facteur.

La somme des courants conduits par les transistors 612 et 618 fournit la limite de courant I_{L} sur la ligne 614, qui est fournie au circuit limiteur de courant de rangée sélectionnée 302.

Le circuit 302 comprend par exemple un premier miroir de courant constitué de transistors PMOS 620 et 622 ayant chacun leur source couplée au rail de tension d'alimentation VDDH. Les noeuds de commande des transistors 620 et 622 sont couplés entre eux et au drain du transistor 620, de sorte que le transistor 620 forme la branche de référence du miroir de courant. Le drain du transistor 622 est par exemple couplé à un noeud 624, qui est à son tour couplé au rail de masse par l'intermédiaire d'une résistance 626. Le noeud 624 fournit une tension V_{L} basée sur le courant I_{L}, et est couplé à une première entrée d'un comparateur 628, qui est par exemple mis en oeuvre par un amplificateur opérationnel.

Le comparateur 628 compare la tension V_{L} à une tension de rétroaction V_{FB}. La tension de rétroaction V_{FB} est fournie par un noeud 630 couplé au rail de masse par l'intermédiaire d'une résistance 631. Un courant passant dans la résistance 631 est fourni par un miroir de courant formé par un transistor PMOS 632 couplé en série avec la résistance 631, et un transistor PMOS 634. Les transistors 632, 634 ont leurs sources couplées au rail d'alimentation VDDH, et leurs noeuds de commande couplés entre eux et au drain du transistor 634, de sorte que le transistor 634 forme une branche de référence du miroir de courant. Le drain du transistor 634 est couplé à la piste conductrice de rangée sélectionnée (SELECTED WL), notée 636 en figure 6, par l'intermédiaire d'un transistor NMOS 638. Le transistor 638 forme un régulateur de tension pour appliquer la tension Vsel à la piste conductrice de rangée sélectionnée. Par exemple, le noeud de commande du transistor 638 est couplé à la sortie d'un comparateur 640, qui est par exemple mis en oeuvre par un amplificateur opérationnel, et qui a son entrée négative couplée à la piste conductrice de rangée sélectionné 636, et son entrée positive couplée à la sortie d'un multiplexeur 642. Une entrée du multiplexeur 642 reçoit le niveau de tension Vsel, et l'autre entrée du multiplexeur 642 est par exemple couplée à la masse, ou à Vusel. Le multiplexeur 642 est contrôlé par le signal de sortie S_OUT du comparateur 628.

En fonctionnement, au début de la phase de programmation de la cellule mémoire sélectionnée, le signal S_OUT sur la sortie du comparateur 628 est par exemple bas, et ainsi contrôle le multiplexeur 642 pour fournir la tension Vsel au comparateur 640. La piste conductrice de rangée sélectionnée 638 est ainsi amenée à la tension Vsel, et le courant de programmation va commencer à monter. Pendant la phase de programmation, les circuits 304, 306 et 308 génèrent la limite de courant I_{L}. Le circuit 302 convertit la limite de courant I_{L} en un niveau de tension V_{L}, et utilise le miroir de courant formé par les transistors 632 et 634, et la résistance 631, pour générer la tension de rétroaction V_{FB} sur la base du niveau du courant IWL sur la piste conductrice de rangée sélectionnée 636. Ces tensions V_{FB} et V_{L} sont comparées par le comparateur 628. Lorsque le courant IWL sur la piste conductrice de rangée sélectionnée atteint la limite de courant I_{L}, le signal de sortie S_OUT du comparateur 628 passe par exemple à l'état haut, amenant le multiplexeur 642 à coupler l'entrée du comparateur à la masse ou à un autre niveau bas, de sorte que le courant de programmation est stoppé ou réduit de façon significative.

Tous les transistors se trouvant dans le circuit de la figure 6 sont par exemple des transistors MOS à canal N (NMOS) ou des transistors MOS à canal P (PMOS), et il apparaitra à l'homme de l'art que, dans des variantes de réalisation, un ou plusieurs des transistors PMOS pourraient être remplacés par des transistors NMOS, et vice versa. Par exemple, les transistors NMOS 604 et 638 pourraient être remplacés par des transistors PMOS, et dans un tel cas, les entrées positives et négatives des comparateurs correspondants 606, 640 sont aussi interverties.

La figure 7 illustre le dispositif mémoire de la figure 3 selon une variante de réalisation par rapport à la figure 6. De nombreux éléments du circuit de la figure 7 sont identiques à des éléments du circuit de la figure 6, et ces éléments portent les mêmes références et ne seront pas décrits de nouveau en détail.

Les circuits 304, 306 et 308 de la figure 7 sont par exemple mis en oeuvre de la même manière qu'en figure 6, et ces circuits ne seront pas décrits de nouveau. Le circuit 302 est toutefois modifié pour retirer le comparateur 628 et le multiplexeur 642. A la place, la limite de courant I_{L} est appliquée à la branche de référence d'un miroir de courant formé par des transistors PMOS 702 et 704 ayant leurs noeuds de commande couplés entre eux et au drain du transistor 702. Le transistor 702 est couplé entre la ligne 614 et le rail d'alimentation VDDH, et le transistor 704 est couplé en série avec le transistor 638. Le comparateur 640 reçoit, sur son entrée négative, le niveau de tension Vsel.

Ainsi, dans le mode de réalisation de la figure 7, le courant IWL sur la piste conductrice de rangée sélectionnée 636 est directement limité par le miroir de courant formé par les transistors 702 et 704. En fonctionnement, au début de la phase de programmation, le courant IWL va être inférieur au courant I_{L}, et va commencer à monter, mais dès qu'il atteint la limite de courant I_{L}, il ne va plus monter.

Il n'y a par exemple aucune détection de la fin de la phase d'écriture dans le circuit de la figure 7. En variante, bien que cela ne soit pas représenté en figure 7, il serait possible de coupler l'entrée positive du comparateur 640 à la sortie d'un multiplexeur 642 comme en figure 6, avec une entrée du multiplexeur 642 couplée à Vsel, et l'autre à la masse ou à la tension Vusel. Dans un tel cas, plutôt que d'être contrôlé par le comparateur 628 (non présent en figure 7), le multiplexeur 642 pourrait par exemple être contrôlé par un inverseur ayant son entrée connectée à la ligne 636. Avant que la limite de courant I_{L} n'ait été atteinte, la tension sur la ligne 636 va être relativement haute, et l'inverseur va fournir une tension basse contrôlant le multiplexeur 642 pour fournir la tension Vsel au comparateur 640. Toutefois, lorsque la limite de courant I_{L} est atteinte, la tension sur la ligne 636 va chuter, et la sortie de l'inverseur va passer à l'état haut, contrôlant le multiplexeur 642 pour fournir la tension de masse ou une autre tension basse au comparateur 640.

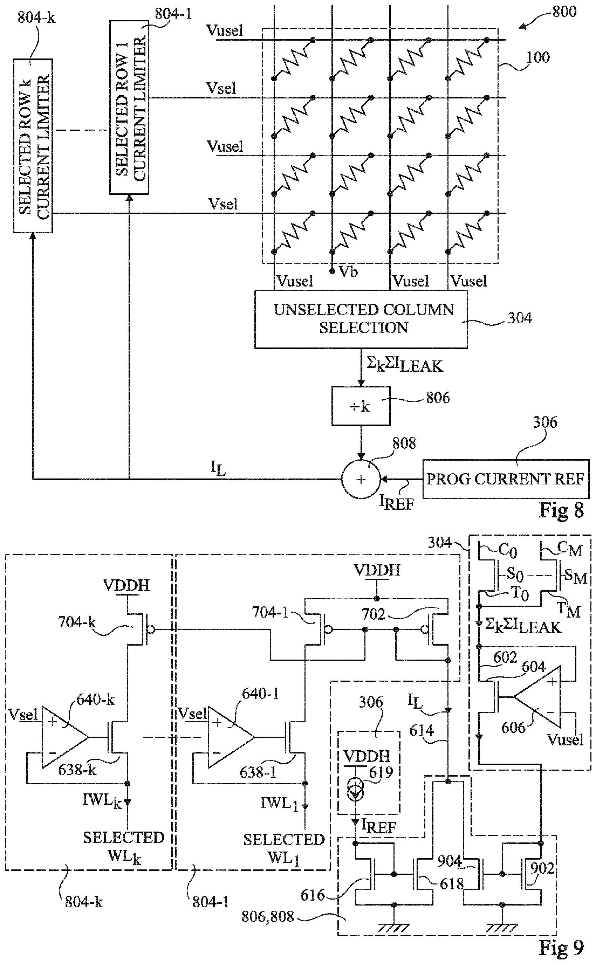

Dans les modes de réalisation des figures 3 et 4, une seule cellule mémoire de la matrice est sélectionnée et programmée pendant chaque phase de programmation. Dans des variantes de réalisation, plusieurs cellules mémoires d'une colonne donnée pourrait être sélectionnées et programmées en même temps, comme on va le décrire maintenant en faisant référence à la figure 8.

La figure 8 illustre schématiquement un dispositif mémoire 800 selon un autre exemple de réalisation, comprenant la même matrice mémoire 100 qu'en figure 1.

Le dispositif mémoire 800 comprend un premier circuit limiteur de courant de rangée sélectionnée (SELECTED ROW 1 CURRENT LIMITER) 804-1 couplé à une première rangée 1 sélectionnée de la matrice mémoire. Le dispositif mémoire comprend aussi un ou plusieurs autres circuits limiteurs de courant, jusqu'à un k-ième circuit (SELECTED ROW k CURRENT LIMITER) 804-k, couplé respectivement à une ou plusieurs autres rangées sélectionnées de la matrice mémoire.

Une seule piste conductrice de colonne sélectionnée est par exemple couplée à la tension V_{b}, et les autres pistes conductrices de colonne sont couplées au circuit de sélection de colonne non sélectionnée 304. Puisque plus qu'une seule des rangées reçoit un courant de programmation, la sortie du circuit 304 est un courant **∑*ₖ*∑*I_{LEAK}*** égal à la somme des courants de fuite générés par les k courants de programmation. Ce courant est par exemple fourni à un circuit 806, qui divise le courant par k, afin de générer un courant de fuite moyen par rangée sélectionnée. Le résultat de la division est par exemple fourni à un additionneur 808, qui l'additionne au courant de référence I_{REF} fourni par le circuit 306, et fournit une limite de courant I_{L}, qui est fournie à chacun des circuits 804-1 à 804-k.

Bien sûr, dans des variantes de réalisation, les circuits 804-1 à 804-k pourraient fournir la tension V_{b} à des pistes conductrices de rangée sélectionnées plutôt que la tension Vsel, et un circuit de sélection de colonne (non illustré en figure 8), pourrait appliquer la tension V_{b} à la piste conductrice de colonne sélectionnée.

La figure 9 illustre schématiquement le dispositif mémoire 800 de la figure 8 plus en détail selon un exemple de réalisation.

Les circuits 304 et 306 sont par exemple les mêmes que ces circuits dans la figure 6 et ne seront pas décrits de nouveau en détail.

Les circuits 806 et 808 pour diviser le courant **∑*k*∑*I_{LEAK}*** par k et pour additionner le résultat au courant I_{REF} sont par exemple mis en oeuvre par un circuit similaire au circuit de l'additionneur 308 de la figure 6. Toutefois, les transistors 610 et 612 du miroir de courant recevant le courant **∑*I_{LEAK}*** sont remplacés par des transistors 902 et 904 respectivement. Les largeurs des transistors 902 et 904 sont par exemple différentes afin de mettre en oeuvre la fonction de division du circuit 806. Par exemple, en appelant W la largeur du transistor 902, la largeur du transistor 904 est par exemple W/k.

Les circuits de limitation de courant 804-1 à 804-k sont chacun par exemple mis en oeuvre par un circuit similaire au circuit 302 de la figure 7, excepté que le transistor 702 est par exemple mis en oeuvre dans un seul de ces circuits, par exemple dans le circuit 804-1, et chacun des circuits 804-1 à 804-k comprend le transistor 704-1 à 704-k ayant respectivement sa grille couplée à la ligne 614 afin de limiter le courant sur la piste conductrice de rangée sélectionnée correspondante au niveau I_{L}. Chacun des circuits 804-1 à 804-k comprend un transistor correspondant 638-1 à 638-k et un multiplexeur correspondant 640-1 à 640-k couplé à la piste conductrice de rangée sélectionnée correspondante IWL₁ à IWLₖ.

Un avantage des modes de réalisation décrits ici est que les courants de fuite dans une matrice mémoire à points d'intersection peuvent être compensés d'une manière simple et précise.

Avec la description ainsi faite d'au moins un mode de réalisation illustratif, diverses altérations, modifications et améliorations apparaîtront facilement à l'homme de l'art. Par exemple il apparaitra à l'homme de l'art que bien qu'on ait décrit un circuit comprenant des transistors MOS, dans des variantes de réalisation, on pourrait utiliser des technologies de transistors différentes, comme la technologie bipolaire.

En outre, il sera clair pour l'homme de l'art que le niveau de la tension d'alimentation VDDH va dépendre de la technologie particulière utilisée pour l'élément résistif, et que plutôt que les circuits soient couplés à une tension de masse, ils pourraient être couplés à un niveau de tension différent, qui pourrait être négatif.

## Revendications

1. Dispositif mémoire comprenant :
une matrice mémoire à points d'intersection (100) comprenant une pluralité de pistes conductrices de rangée (102), une pluralité de pistes conductrices de colonne (104) et une pluralité de cellules mémoires (106) agencées en rangées et en colonnes, chaque cellule mémoire (106) comprenant un élément résistif programmable non volatil (108) couplé entre l'une correspondante des pistes conductrices de rangée et l'une correspondante des pistes conductrices de colonne ;
un circuit d'alimentation en courant (302, 402) adapté à fournir un courant de programmation (IWL) à l'une sélectionnée des pistes conductrices de rangée pendant une opération de programmation pour changer l'état résistif d'une cellule mémoire sélectionnée couplée entre la piste conductrice de rangée sélectionnée et l'une sélectionnée des pistes conductrices de colonne ;
un circuit de détection de courants de fuite (304) couplé à la pluralité de pistes conductrices de colonne (104) excepté à la piste conductrice de colonne sélectionnée et adapté à détecter des courants de fuite pendant l'opération de programmation ; et
un circuit de génération de limite de courant (308) adapté à générer une limite de courant (I_{L}) sur la base de la somme des courants de fuite et d'un courant de référence (I_{REF}), et à fournir la limite de courant au circuit d'alimentation en courant (302) pour limiter le courant de programmation.

2. Dispositif mémoire selon la revendication 1, dans lequel le circuit de génération de limite de courant (308) est adapté à générer la limite de courant (I_{L}) en ajoutant la somme des courants de fuite au courant de référence (I_{REF}), dans lequel le courant de référence représente le courant de programmation à appliquer à la cellule mémoire sélectionnée.

3. Dispositif mémoire selon la revendication 1 ou 2, dans lequel le circuit d'alimentation en courant (302) comprend un régulateur de tension (638, 640) pour contrôler un premier niveau de tension (Vsel) appliqué à la piste conductrice de rangée sélectionnée.

4. Dispositif mémoire selon la revendication 3, dans lequel le régulateur de tension (638, 640) comprend un premier transistor (638) couplé à la piste conductrice de rangée sélectionnée et ayant son noeud de commande couplé à la sortie d'un comparateur (640) adapté à comparer la tension sur la piste conductrice de rangée sélectionnée à une tension de référence égale au premier niveau de tension (Vsel).

5. Dispositif mémoire selon l'une quelconque des revendications 1 à 4, dans lequel le circuit d'alimentation en courant (302) comprend un miroir de courant (702, 704) ayant une branche de référence (702) couplée de façon à recevoir la limite de courant (I_{L}) et une autre branche (704) couplée à la piste conductrice de rangée sélectionnée.

6. Dispositif mémoire selon l'une quelconque des revendications 1 à 4, dans lequel le circuit d'alimentation en courant (302) comprend un autre comparateur (628) adapté à comparer un premier niveau de tension (V_{L}) généré sur la base de la limite de courant (I_{L}) à un deuxième niveau de tension (V_{FB}) généré sur la base du courant de programmation, et à contrôler le courant de programmation sur la base de la comparaison.

7. Dispositif mémoire selon l'une quelconque des revendications 1 à 6, dans lequel le circuit de détection de courants de fuite (304) comprend un régulateur de tension (604, 606) pour contrôler un deuxième niveau de tension (Vusel) appliqué aux pistes conductrices de colonne (104) excepté à la piste conductrice de colonne sélectionnée.

8. Dispositif mémoire selon l'une quelconque des revendications 1 à 7, dans lequel le circuit de génération de limite de courant (308) comprend :
un premier miroir de courant (610, 612) ayant une branche de référence (610) couplée de façon à recevoir la somme des courants de fuite, et une autre branche (612) ;
un deuxième miroir de courant ayant une branche de référence (616) couplée de façon à recevoir le courant de référence (I_{REF}), et une autre branche (618), les autres branches (612, 618) des premier et deuxième miroirs de courant étant couplées à une ligne de sortie (614) du circuit de génération de limite de courant (308) fournissant la limite de courant (I_{L}).

9. Dispositif mémoire selon l'une quelconque des revendications 1 à 8, comprenant :
un ou plusieurs autres circuits d'alimentation en courant (804-k) adaptés à fournir un courant de programmation (IWLₖ) à une ou plusieurs autres pistes conductrices de rangée sélectionnées pendant l'opération de programmation pour changer l'état résistif d'une ou plusieurs des cellules mémoires couplées à la piste conductrice de colonne sélectionnée ; et
un circuit de division (806) adapté à diviser la somme des courants de fuite par le nombre de circuits d'alimentation en courant.

10. Dispositif mémoire selon l'une quelconque des revendications 1 à 9, dans lequel l'élément résistif programmable non volatil (108) est l'un des éléments suivants :
un dispositif OxRAM (mémoire à accès aléatoire à oxyde) ;
un dispositif PCM (mémoire à changement de phase) ; et
un dispositif MRAM (RAM magnétique).

11. Dispositif mémoire selon l'une quelconque des revendications 1 à 10, dans lequel chaque cellule mémoire comprend en outre un dispositif à sélection bidirectionnelle (110) couplé en série avec l'élément résistif programmable non volatil et adapté à conduire au-dessus d'un seuil de tension (Vt).

12. Procédé pour limiter un courant de programmation dans une matrice de mémoire non volatile à points d'intersection (100) comprenant une pluralité de pistes conductrices de rangée (102), une pluralité de pistes conductrices de colonne (104) et une pluralité de cellules mémoires (106) agencées en rangées et en colonnes, chaque cellule mémoire (106) comprenant un élément résistif programmable non volatil (108) couplé entre l'une correspondante des pistes conductrices de rangée et l'une correspondante des pistes conductrices de colonne, le procédé comprenant :
fournir, par un circuit d'alimentation en courant (302), un courant de programmation (IWL) à l'une sélectionnée des pistes conductrices de rangée pendant une opération de programmation pour changer l'état résistif d'une cellule mémoire sélectionnée couplée entre la piste conductrice de rangée sélectionnée et l'une sélectionnée des pistes conductrices de colonne ;
détecter, par un circuit de détection de courants de fuite (304) couplé à la pluralité de pistes conductrices de colonne (104) excepté à la piste conductrice de colonne sélectionnée, des courants de fuite pendant l'opération de programmation ;
générer, par un circuit de génération de limite de courant (308), une limite de courant (I_{L}) sur la base de la somme des courants de fuite et d'un courant de référence (I_{REF}) ; et
fournir la limite de courant (I_{L}) au circuit d'alimentation en courant (302) pour limiter le courant de programmation.

## Patentansprüche

1. Eine Speichervorrichtung, die Folgendes aufweist:
einen Kreuzungspunktspeicheranordnung (100), die eine Vielzahl von Zeilenleiterbahnen (102), eine Vielzahl von Spaltenleiterbahnen (104) und eine Vielzahl von Speicherzellen (106) aufweist, die in Zeilen und Spalten angeordnet sind, wobei jede Speicherzelle (106) ein nichtflüchtiges programmierbares Widerstandselement (108) aufweist, das zwischen einer entsprechenden der Zeilenleiterbahnen und einer entsprechenden der Spaltenleiterbahnen gekoppelt ist;
eine Stromversorgungsschaltung (302, 402), die geeignet ist zum Liefern eines Programmierstrom (IWL) an eine ausgewählte der Zeilenleiterbahnen während eines Programmierbetriebs, um den Widerstandszustand einer ausgewählten Speicherzelle zu ändern, die zwischen der ausgewählten Zeilenleiterbahn und einer ausgewählten der Spaltenleiterbahnen gekoppelt ist;
eine Leckstromdetektionsschaltung (304), die mit der Vielzahl von Spaltenleiterbahnen (104) verbunden ist, mit Ausnahme der ausgewählten Spaltenleiterbahn, und die geeignet ist, Leckströme während des Programmierbetriebs zu detektieren; und
eine Strombegrenzungs-Erzeugungsschaltung (308), die geeignet ist zum Erzeugen einer Strombegrenzung (I_{L}) basierend auf der Summe der Leckströme und eines Referenzstroms (I_{REF}) und zum Liefern der Strombegrenzung zu der Stromversorgungsschaltung (302) zum Begrenzen des Programmierstroms.

2. Speichervorrichtung nach Anspruch 1, wobei die Strombegrenzungs-Erzeugungsschaltung (308) geeignet ist zum Erzeugen der Strombegrenzung (I_{L}) durch Addieren der Summe der Leckströme zu dem Referenzstrom (I_{REF}), wobei der Referenzstrom den Programmierstrom repräsentiert, der an die ausgewählte Speicherzelle angelegt werden soll.

3. Speichervorrichtung nach Anspruch 1 oder 2, wobei die Stromversorgungsschaltung (302) einen Spannungsregler (638, 640) zum Steuern eines ersten Spannungspegels (Vsel) aufweist, der an die ausgewählte Zeilenleiterbahn angelegt wird.

4. Speichervorrichtung nach Anspruch 3, wobei der Spannungsregler (638, 640) einen ersten Transistor (638) aufweist, der mit der ausgewählten Zeilenleiterbahn gekoppelt ist und dessen Steuerknoten mit dem Ausgang eines Komparators (640) gekoppelt ist, der geeignet ist zum Vergleichen der Spannung an der ausgewählten Zeilenleiterbahn mit einer Referenzspannung mit dem ersten Spannungspegel (Vsel).

5. Speichervorrichtung nach einem der Ansprüche 1 bis 4, wobei die Stromversorgungsschaltung (302) einen Stromspiegel (702, 704) aufweist mit einem Referenzzweig (702), der zum Empfangen der Strombegrenzung (I_{L}) gekoppelt ist, und einem weiteren Zweig (704), der an die ausgewählte Zeilenleiterbahn gekoppelt ist.

6. Speichervorrichtung nach einem der Ansprüche 1 bis 4, wobei die Stromversorgungsschaltung (302) einen weiteren Komparator (628) aufweist, der geeignet ist zum Vergleichen eines ersten Spannungspegel (V_{L}), der basierend auf der Stromgrenze (I_{L}) erzeugt wird, mit einem zweiten Spannungspegel (V_{FB}), der basierend auf dem Programmierstrom erzeugt wird, und zum Steuern des Programmierstroms basierend auf dem Vergleich.

7. Speichervorrichtung nach einem der Ansprüche 1 bis 6, wobei die Leckstromdetektionsschaltung (304) einen Spannungsregler (604, 606) zum Steuern eines zweiten Spannungspegels (Vusel) aufweist, der an die Spaltenleiterbahnen (104) angelegt wird mit Ausnahme der ausgewählten Spaltenleiterbahn.

8. Speichervorrichtung nach einem der Ansprüche 1 bis 7, wobei die Strombegrenzungs-Erzeugungsschaltung (308) Folgendes aufweist:
einen ersten Stromspiegel (610, 612) mit einem Referenzzweig (610), der gekoppelt ist zum Empfangen der Summe der Leckströme, und mit einem weiteren Zweig (612);
einen zweiten Stromspiegel mit einem Referenzzweig (616), der gekoppelt ist zum Empfangen des Referenzstroms (I_{REF}) und mit einem weiteren Zweig (618), wobei die weiteren Zweige (612, 618) der ersten und zweiten Stromspiegel an eine Ausgangsleiterbahn (614) der Strombegrenzungs-Erzeugungsschaltung (308) gekoppelt sind, um die Strombegrenzung (I_{L}) vorzusehen;

9. Speichervorrichtung nach einem der Ansprüche 1 bis 8, die Folgendes aufweist:
eine oder mehrere weitere Stromversorgungsschaltungen (804-k), die geeignet sind zum Liefern eines Programmierstroms (IWLₖ) an eine oder mehr weitere ausgewählte Zeilenleiterbahnen während des Programmierbetriebs zum Ändern des Widerstandszustandes von einer oder mehrerer Speicherzelle/n, die an die ausgewählte Spaltenleiterbahn gekoppelt ist; und
eine Teilungsschaltung (806), die geeignet ist zum Teilen der Summe der Leckströme durch die Anzahl der Stromversorgungsschaltungen.

10. Speichervorrichtung nach einem der Ansprüche 1 bis 9, wobei das nichtflüchtige programmierbare Widerstandselement (108) eines der Folgenden ist:
eine OxRAM- (Oxide Random Access Memory) Vorrichtung;
eine PCM- (Phase Change memory) Vorrichtung; und
eine MRAM- (magnetic RAM) Vorrichtung.

11. Speichervorrichtung nach einem der Ansprüche 1 bis 10, wobei jede Speicherzelle ferner eine Zweiwegselektionsvorrichtung (110) aufweist, die in Zeile mit dem nichtflüchtigen programmierbaren Widerstandselement gekoppelt ist, und die geeignet ist zum Leiten oberhalb einer Schwellenwertspannung (Vt).

12. Verfahren zur Begrenzung eines Programmierstroms in einer nichtflüchtigen Kreuzpunktspeicheranordnung (100), die eine Vielzahl von Zeilenleiterbahnen (102), eine Vielzahl von Spaltenleiterbahnen (104) und eine Vielzahl von Speicherzellen (106) aufweist, die in Zeilen und Spalten angeordnet sind, wobei jede Speicherzelle (106) ein nichtflüchtiges programmierbares Widerstandselement (108) aufweist, das zwischen einer entsprechenden der Zeilenleiterbahnen und einer entsprechenden der Spaltenleiterbahnen gekoppelt ist, wobei das Verfahren Folgendes aufweist:
Liefern durch eine Stromversorgungsschaltung (302) eines Programmierstroms (IWL) an eine ausgewählte der Zeilenleiterbahnen während eines Programmierbetriebs zum Ändern des Widerstandzustandes einer ausgewählten Speicherzelle, die zwischen der ausgewählten Zeilenleiterbahn und einer ausgewählten der Spaltenleiterbahn gekoppelt ist;
Detektieren durch eine Leckstromdetektionsschaltung (304), die an die Vielzahl der Spaltenleiterbahnen (104) gekoppelt ist mit Ausnahme der ausgewählten Spaltenleiterbahn, von Leckströmen während des Programmierbetriebs;
Erzeugen durch eine Strombegrenzungs-Erzeugungsschaltung (308) eine Strombegrenzung (I_{L}) basierend auf der Summe der Leckströme und eines Referenzstroms (I_{REF}); und
Liefern der Strombegrenzung (I_{L}) an die Stromversorgungsschaltung (302) zum Begrenzen des Programmierstroms.

## Claims

1. A memory device comprising:
a cross-point memory array (100) comprising a plurality of row lines (102), a plurality of column lines (104) and a plurality of memory cells (106) arranged in rows and columns, each memory cell (106) comprising a non-volatile programmable resistive element (108) coupled between a corresponding one of the row lines and a corresponding one of the column lines;
a current supply circuit (302, 402) adapted to supply a programming current (IWL) to a selected one of the row lines during a programming operation to change the resistive state of a selected memory cell coupled between the selected row line and a selected one of the column lines;
a leakage current detection circuit (304) coupled to the plurality of column lines (104) except the selected column line and adapted to detect leakage currents during said programming operation; and
a current limit generation circuit (308) adapted to generate a current limit (I_{L}) based on the sum of the leakage currents and on a reference current (I_{REF}), and to supply said current limit to the current supply circuit (302) to limit said programming current.

2. The memory device of claim 1, wherein the current limit generation circuit (308) is adapted to generate the current limit (I_{L}) by adding the sum of the leakage currents to the reference current (I_{REF}), wherein the reference current represents the programming current to be applied to the selected memory cell.

3. The memory device of claim 1 or 2, wherein the current supply circuit (302) comprises a voltage regulator (638, 640) for controlling a first voltage level (Vsel) applied to the selected row line.

4. The memory device of claim 3, wherein the voltage regulator (638, 640) comprises a first transistor (638) coupled to the selected row line and having its control node coupled to the output of a comparator (640) adapted to compare the voltage on the selected row line with a reference voltage at the first voltage level (Vsel).

5. The memory device of any of claims 1 to 4, wherein the current supply circuit (302) comprises a current mirror (702, 704) having a reference branch (702) coupled to receive the current limit (I_{L}) and a further branch (704) coupled to the selected row line.

6. The memory device of any of claims 1 to 4, wherein the current supply circuit (302) comprises a further comparator (628) adapted to compare a first voltage level (V_{L}) generated based on the current limit (I_{L}) with a second voltage level (V_{FB}) generated based on the programming current, and to control the programming current based on said comparison.

7. The memory device of any of claims 1 to 6, wherein the leakage current detection circuit (304) comprises a voltage regulator (604, 606) for controlling a second voltage level (Vusel) applied to the column lines (104) except the selected column line.

8. The memory device of any of claims 1 to 7, wherein the current limit generation circuit (308) comprises:
a first current mirror (610, 612) having a reference branch (610) coupled to receive the sum of the leakage currents and a further branch (612);
a second current mirror having a reference branch (616) coupled to receive the reference current (I_{REF}) and a further branch (618), wherein the further branches (612, 618) of the first and second current mirrors are coupled to an output line (614) of the current limit generation circuit (308) providing the current limit (I_{L}).

9. The memory device of any of claims 1 to 8, comprising:
one or more further current supply circuits (804-k) adapted to supply a programming current (IWLₖ) to one or more further selected row lines during the programming operation to change the resistive state of one or more of the memory cells coupled to the selected column line; and
a division circuit (806) adapted to divide the sum of the leakage currents by the number of current supply circuits.

10. The memory device of any of claims 1 to 9, wherein the non-volatile programmable resistive element (108) is one of:
an OxRAM (Oxide Random Access Memory) device;
a PCM (Phase Change memory) device; and
an MRAM (magnetic RAM) device.

11. The memory device of any of claims 1 to 10, wherein each memory cell further comprises a two-way selection device (110) coupled in series with the non-volatile programmable resistive element and adapted to conduct above a threshold voltage (Vt).

12. A method of limiting a programming current in a cross-point non-volatile memory array (100) comprising a plurality of row lines (102), a plurality of column lines (104) and a plurality of memory cells (106) arranged in rows and columns, each memory cell (106) comprising a non-volatile programmable resistive element (108) coupled between a corresponding one of the row lines and a corresponding one of the column lines, the method comprising:
supplying, by a current supply circuit (302), a programming current (IWL) to a selected one of the row lines during a programming operation to change the resistive state of a selected memory cell coupled between the selected row line and a selected one of the column lines;
detecting, by a leakage current detection circuit (304) coupled to the plurality of column lines (104) except the selected column line, leakage currents during said programming operation;
generating, by a current limit generation circuit (308), a current limit (I_{L}) based on the sum of the leakage currents and on a reference current (I_{REF}); and
supplying said current limit (I_{L}) to the current supply circuit (302) to limit said programming current.
